# EUROPÄISCHE PATENTSCHRIFT

(11) **EP 1 825 518 B1**
(45) Veröffentlichungstag und Bekanntmachung des Hinweises auf die Patenterteilung: **01.04.2015**
(21) Anmeldenummer: 05812829.9
(22) Anmeldetag: 09.12.2005
(51) Int. Cl.: H01L 29/739, H01L 29/08

(54) **Verfahren zur Herstellung eines Leistungshalbleiters**
Method for fabricating a power semiconductor
Procédé de fabrication d'un semi-conducteur de puissance

(30) Priorität: 16.12.2004 EP 04405775
(43) Veröffentlichungstag der Anmeldung: 29.08.2007
(73) Patentinhaber: ABB Technology AG, 8050 Zürich (CH)
(72) Erfinder: RAHIMO, Munaf, CH-5619 Uezwil (CH); KOPTA, Arnost, CH-8045 Zürich (CH); LINDER, Stefan, CH-4800 Zofingen (CH)
(74) Vertreter: ABB Patent Attorneys
(86) Internationale Anmeldenummer: PCT/CH2005/000737
(87) Internationale Veröffentlichungsnummer: WO 2006/063478

(56) Entgegenhaltungen:
- EP-A- 0 657 941
- EP-A- 1 237 200
- DE-A1- 19 814 115

## Beschreibung

### Technisches Gebiet

Die Erfindung bezieht sich auf das Gebiet der Leistungselektronik. Sie bezieht sich ein Verfahren zur Herstellung eines Leistungshalbleiters für den Betrieb bei hohen Blockierspannungen gemäss Oberbegriff des Patentanspruches 1.

### Stand der Technik

Bei Non-Punch-Through- (NPT-) Insulated Gate Bipolar Transistors (IGBTs), wie sie beispielsweise in der Druckschrift von J. Yamashita et al. (IEEE 1997, S. 109-112) beschrieben sind, grenzt eine niedrig dotierte Driftschicht eines ersten Ladungsträgertyps direkt an die Elektrode eines zweiten Ladungsträgertyps an. Diese IGBTs zeichnen sich dadurch aus, dass im Vergleich zu den im folgenden beschriebenen Punch-Through- (PT-) IGBTs die Driftschicht zur Aufnahme einer hohen Blockierspannung eine grössere Dicke und höhere Dotierung aufweist. Wegen der grösseren Dicke der Driftschicht werden höhere Verluste im IGBT generiert. Im Falle eines Fehlers kann während des Einschaltens des IGBT's ein Kurzschlussstrom mit kurzer Stromspitze auftreten, oder es können Kurzschlussstrompulse während des Betriebs im eingeschalteten Zustand des IGBT's auftreten. In Folge eines solchen Kurzschlussstromes kann der IGBT seine Gatesteuerung verlieren und der Strom kann weiter bis hin zur Zerstörung des IGBT's steigen. Bei NPT-IGBTs ist vorteilhaft, dass die Elektroden-Injektionseffizienz niedrig gehalten werden kann, ohne dass die Robustheit des IGBT's unter Kurzschluss-Bedingungen negativ beeinflusst wird.

Bei Punch-Through- (PT-) IGBTs wird zwischen der Driftschicht und der Elektrode eine hochdotierte Stoppschicht des ersten Ladungsträgertyps eingeführt, wodurch es möglich wird, im Vergleich zu NPT-IGBTs bei denselben Blockierspannungen dünnere Driftschichten zu verwenden. Der Widerstand wird dadurch verringert und beim eingeschalteten IGBT ebenso wie beim Schalten des IGBTs treten geringere Verluste auf. Allerdings ist die Robustheit der PT-IGBT's unter Kurzschlussbedingungen schlechter als bei den NPT-IGBTs.

Um die Vorteile der PT-IGBTs mit denen der NPT-IGBTs zu verbinden, sind Soft-Punch-Through- (SPT-) IGBTs entwickelt worden, deren Stoppschicht zwar höher dotiert ist als die Driftschicht, aber niedriger dotiert als die Stoppschicht eines PT-IGBT's. Die Stoppschicht wird erzeugt, indem Teilchen des ersten Ladungsträgertyps tief in eine Schicht desselben Ladungsträgertyps eindiffundiert werden. Derart erzeugte Stoppschichten weisen eine Dicke von 5 - 60 µm auf. Um die Teilchen tief in die Schicht einzutreiben, sind lange Diffusionszeiten erforderlich. Dadurch werden Defekte in der Schicht erzeugt, welche die Blockierspannung erheblich reduzieren können.

Das Dokument EP 1 237 200 beschreibt ein Verfahren zur Herstellung von Leistungshalbleiters für den Betrieb bei niedrigen Blockierspannungen bis zu 600 V. Auf einer n-dotierten, 625 µm dicken ersten Stoppschicht lässt man eine 25 bis 60 µm dünne (n-)-dotierte Driftschicht epitaktisch aufwachsen. Dann wird der Emitter erzeugt und anschliessend die n-dotierte Schicht abgeschnitten bis auf einen verbleibenden Teil, so dass die Gesamtdicke des Wafers vom Emitter bis zur n-dotierten Schicht 60 bis 80 µm beträgt. Eine zweite, (n+) dotierte Stoppschicht wird durch Diffusion in der n-dotierten Schicht an der Seite, an der die Schicht abgeschnitten wurde, erzeugt und an dieser Seite eine Anode gebildet. Zur Erzeugung der zweiten Stoppschicht wird der Wafer durch das Diffusionsverfahren hohen Temperaturen ausgesetzt, was problematisch ist für den zuvor erzeugten Emitter. Durch die Einführung der zweiten Stoppschicht wird bei Halbleitern mit niedrigen Blockierspannungen die Anodeninjektion und der Punch-Through kontrolliert. Dieses Verfahren ist nur geeignet zur Herstellung von Leistungshalbleitern für den Betrieb bei niedrigen Blockierspannungen, weil die Driftschicht bei derartigen Halbleitern dünn ist, und somit das Verfahren zur Erzeugung der Driftschicht mittels epitaktischem Wachsen noch wirtschaftlich vertretbar ist.

### Darstellung der Erfindung

Aufgabe der Erfindung ist es, ein Verfahren zur Herstellung eines Leistungshalbleiters für den Betrieb bei hohen Blockierspannungen, vorzugsweise eines IGBT's, anzugeben, der eine höhere Robustheit unter Kurzschlussbedingungen (verbesserte "Short circuit safe operating area", kurz: SCSOA) bei gleichzeitig reduzierten Verlusten, Leckströmen und Defekten aufweist.

Die Aufgabe wird gelöst durch ein Verfahren gemäß Anspruch 1.

Eine mit dem erfndungsgemässen Verfahren hergestellter Hochspannungs-Leistungshalbleiters für den Betrieb bei hohen Blockierspannungen, insbesondere bei Blockierspannungen oberhalb von 2000 V, umfasst eine Driftschicht (2) mit einer Dotierung eines ersten Ladungsträgertyps, eine erste Stoppschicht (3) mit einer Dotierung des ersten Ladungsträgertyps und eine Elektrode (5) eines zweiten Ladungsträgertyps, wobei die Dotierung der ersten Stoppschicht (3) höher als die Dotierung der Driftschicht (2) ist.

Bei dem erfindungsgemässen Verfahren wird ausgehend von einer niedrig-dotierten Schicht (6) eines ersten Ladungsträgertyps, von welcher niedrig-dotierten Schicht (6) ein im fertigen Halbleiter verbleibender Teil mit niedriger Dotierung die Driftschicht (2) bildet, an einer Seite der niedrig-dotierten Schicht eine mittel-dotierte Schicht (7) erzeugt wird. Von der mittel-dotierten Schicht (7) bildet ein im fertigen Halbleiter verbleibender Teil mit mittlerer Dotierung die erste Stoppschicht (3). Danach wird die Elektrode (5) in diejenige Schicht des ersten Ladungsträgertyps, welche die höchste Dotierung der Schichten des ersten Ladungsträgertyps aufweist, eindiffundiert. Das erfindungsgemässe Verfahren ist dadurch gekennzeichnet, dass nach der Erzeugung der mittel-dotierten Schicht (7) und vor der Erzeugung der Elektrode (5) an derjenigen Seite der mittel-dotierten Schicht (7), welche der niedrig-dotierten Schicht (6) abgewandt ist, eine hoch dotierte Schicht (8) erzeugt wird. Von der hoch dotierten Schicht (8) bildet ein im fertigen Halbleiter verbleibender Teil mit hoher Dotierung eine zweite Stoppschicht (4). Die Dotierung der hoch dotierten Schicht (8) ist höher als die Dotierung der mittel-dotierten Schicht (7). In der ersten Stoppschicht wird das elektrische Feld abgebaut. Die zweite Stoppschicht bewirkt eine Reduzierung von Leck-Strömen.

Weitere vorteilhafte Ausgestaltungen der Erfindung sind in den Unteransprüchen angegeben.

### Kurze Beschreibung der Zeichnungen

Im folgenden wird das erfindungsgemässe Verfahren und der Erfindungsgegenstand anhand von bevorzugten Ausführungsbeispielen, welche in den beiliegenden Zeichnungen dargestellt ist, näher erläutert. Es zeigen:
- FIG 1: Schnitt durch einen erfindungsgemässen Leistungshalbleiter
- FIG 2 bis 5:: Verfahrensschritte zur Herstellung des Leistungshalbleiters nach FIG 1 vom Ausgangsmaterial bis zu einem Stadium, in dem eine Driftschicht mit einer ersten und einer zweiten Stoppschicht verbunden ist unter Verwendung folgender Verfahren:

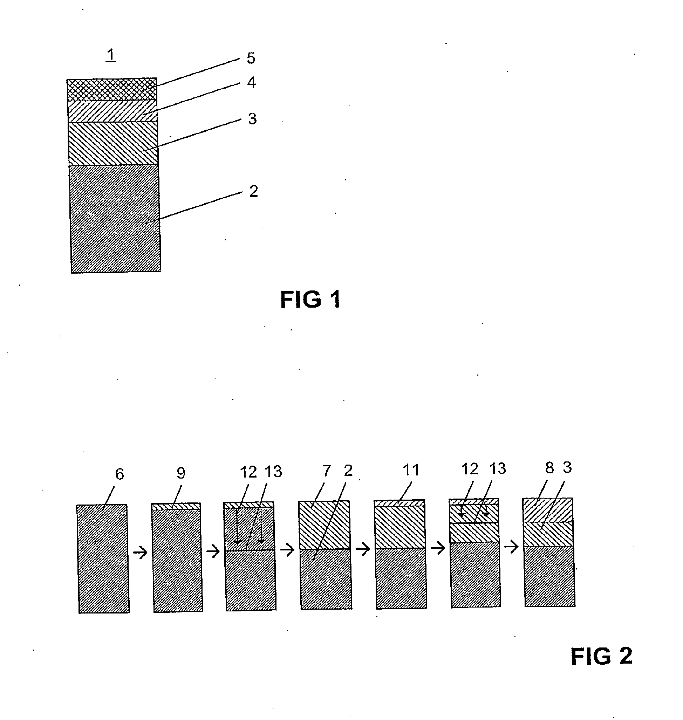

- FIG 2: Diffusionsverfahren;

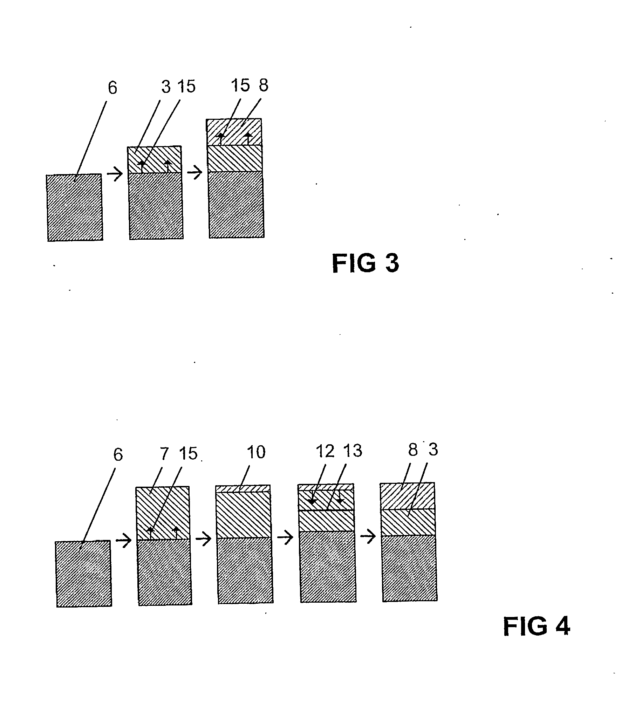

- FIG 3: epitaktisches Wachsen;
- FIG 4: epitaktisches Wachsen, kombiniert mit Diffusionsverfahren;

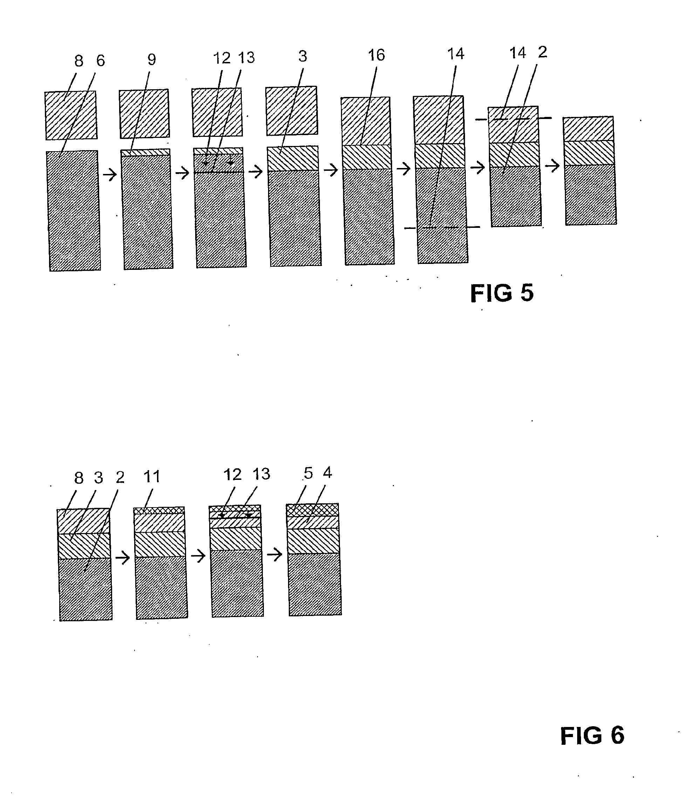

- FIG 5: Diffusionsverfahren, kombiniert mit Bonding und Schneiden;
- FIG 6: Verfahrensschritte zur Herstellung des Leistungshalbleiters nach FIG 1 vom Endstadium gemäss einer der Figuren FIG 2 bis 5 bis zu dem Stadium, in dem die Elektrode zusätzlich eingebracht wird.

### Wege zur Ausführung der Erfindung

Der in FIG 1 dargestellte erfindungsgemässe Leistungshalbleiter 1 umfasst eine dotierte Driftschicht 2 eines ersten Ladungsträgertyps, auf der eine erste Stoppschicht 3 des ersten Ladungsträgertyps mit einer höheren Dotierung angeordnet ist. Auf der ersten Stoppschicht ist eine zweite Stoppschicht 4 des ersten Ladungsträgertyps, die höher dotiert ist als die erste Stoppschicht 3, angeordnet. An die zweite Stoppschicht grenzt eine Elektrode 5 eines zweiten Ladungsträgertyps an. Im folgenden wird die Driftschicht 2 als niedrig dotiert bezeichnet, was so zu verstehen ist, dass die Driftschicht niedriger als die erste Stoppschicht 3 und die zweite Stoppschicht 4 dotiert ist. Die erste Stoppschicht 3 wird als mittel-dotiert bezeichnet, was so zu verstehen ist, dass die erste Stoppschicht 3 höher als die Driftschicht 2 dotiert ist, aber niedriger dotiert ist als die zweite Stoppschicht 4. Die zweite Stoppschicht 4 wird als hoch dotiert bezeichnet, was so zu verstehen ist, dass die zweite Stoppschicht 4 höher als die Driftschicht 2 und die erste Stoppschicht 3 dotiert ist.

Die Driftschicht 2 weist für Anwendung bei hohen Blockierspannungen eine Dicke von mehr als 150 µm und eine Dotierung von weniger als 5 * 10¹³/cm³ auf. Unter hohen Blockierspannungen sind insbesondere Spannungen, welche höher als 2000 V sind, zu verstehen.

In einer Ausführungsform weist die erste Stoppschicht 3 des Leistungshalbleiters 1 eine Dicke von (10 - 30) µm und / oder eine Dotierung von 10¹³ - 2 * 10¹⁵/cm³ im Bereich der Oberfläche auf. Mit einer solchen Auslegung der ersten Stoppschicht 3 kann das elektrische Feld im blockierenden Zustand abgebaut werden, bevor es in die Nähe der Elektrode 5 vordringt. Der Bereich zwischen dem Ende des elektrischen Feldes und der Elektrode 5 ist die Basis des IGBT-internen bipolaren Transistors. Durch eine derart ausgebildete erste Stoppschicht 3 wird dieser Bereich vergrössert und der Leck-Strom im blockierenden Zustand verringert. Mit einer derart niedrigen Dotierung kann aber gleichzeitig eine grosse SCSOA erzielt werden.

Die zweite Stoppschicht 4 weist eine Dicke von (1 - 10) µm und / oder eine Dotierung von 2 * 10¹⁵ - 10¹⁷/cm³ im Bereich der Oberfläche auf. Mit einer solch hohen Dotierung kann die Elektroden-Injektionseffizienz bei niedriger Injektion der Elektrode 5 tief gehalten werden und es können somit niedrige Leck-Ströme im blockierenden Zustand erzielt werden. Mit einer solch geringen Dicke der zweiten Stoppschicht 4 wird die SCSOA nicht vermindert.

Die Elektrode 5 ist in einer Ausführungsform als transparente Elektrode ausgebildet. Diese wird durch ein Diffusionsverfahren erzeugt, wobei zuerst eine Implantation von Teilchen mit einer Dosis von (10¹³ - 10¹⁶)/cm² und nachfolgend eine Aktivierung vorgenommen wird. Die Dicke der Elektrode 5 beträgt weniger als 5 µm. Das Diffusionsverfahren wird im weiteren beschrieben.

Die Schichten eines Leistungshalbleiters 1 können durch ein Diffusionsverfahren und / oder epitaktisches Wachsen erzeugt werden. Zusätzlich können Schichten durch Bonding miteinander verbunden werden und durch Schneiden kann die Dicke einer Schicht reduziert werden. Die Verfahren werden im folgenden kurz erläutert.

Das Diffusionsverfahren wird durchgeführt, indem in eine Schicht, welche mit einem Ladungsträgertyp dotiert ist, Teilchen desselben oder eines anderen Ladungsträgertyps implantiert werden. In FIG 2 werden beispielsweise in einer niedrig dotierten Schicht 6 Teilchen zur Schaffung einer ersten Stoppschicht 3 implantiert. Die implantierten Teilchen sind durch das Bezugszeichen 9 dargestellt. Anschliessend erfolgt eine Aktivierung, indem die implantierten Teilchen 9 in die niedrig dotierte Schicht 6 durch Erhitzen der Schicht bis zu einer vorgegebenen Tiefe 13 eindiffundiert werden. Das Diffundieren der implantierten Teilchen ist in FIG 2 durch die mit dem Bezugszeichen 12 versehenen Pfeile dargestellt. Je höher die Temperatur gewählt wird und je länger das Verfahren des Erhitzens durchgeführt wird, desto tiefer werden die Teilchen in die Schicht eingetrieben. Zur Schaffung einer ersten Stoppschicht 3 werden typischerweise Teilchen eines ersten Ladungsträgertyps 9 implantiert und bei langen Heizzeiten und hohen Temperaturen eingetrieben. Zur Schaffung einer zweiten Stoppschicht 4 werden Teilchen eines ersten Ladungsträgertyps implantiert und die implantierten Teilchen 10 typischerweise über eine kurze Zeit und eine niedrige Temperatur eingetrieben. Die Elektrode 5 wird durch Implantieren von Teilchen eines zweiten Ladungsträgertyps 11 und Diffundieren bei sehr kurzen Zeiten und niedrigen Temperaturen erzeugt.

Unter epitaktischem Wachsen versteht man ein Verfahren, bei welchem eine Halbleiterschicht in einer Gasumgebung hohen Temperaturen ausgesetzt wird. Auf der Oberfläche der Schicht scheiden sich Teilchen aus dem Gas ab, und es bildet sich eine Schicht.

Beim Bonding werden zwei Halbleiterschichten miteinander verbunden, indem sie hohen Temperaturen ausgesetzt werden. Es können Bindemittel zwischen den Schichten zur Verbesserung der Bindung verwendet werden.

Beim Schneiden einer Halbleiterschicht wird typischerweise die Dicke der Schicht durch Abschleifen, Polieren und / oder Ätzen reduziert.

In der folgenden Beschreibung wird nur eingegangen auf die Verfahrensschritte, mit denen die Stoppschichten 3, 4 des Leistungshalbleiters 1 geschaffen werden. Auf weitere Verfahrensschritte zur Herstellung eines Leistungshalbleiters 1, wie beispielsweise das Aufbringen von Metallisierungen oder Isolationen wird nicht eingegangen. Nach dem Aufbringen einer Metallisierung sollte der Leistungshalbleiter beispielsweise keinen hohen Temperaturen mehr ausgesetzt werden, durch welche die Metallisierung beschädigt würde. Daher sollten diese Verfahrensschritte zu einem derartigen Zeitpunkt durchgeführt werden, dass der Leistungshalbleiter bei folgenden Verfahrensschritten nicht mehr Bedingungen wie zu hohen Temperaturen ausgesetzt wird, beispielsweise durch ein Diffusionsverfahren zur Bildung der ersten und / oder zweiten Stoppschicht, die zur Beschädigung des Halbleiters führen. Alternativ können die Stoppschichten 3, 4 auch mit der Hilfe von schnell diffundierenden Dopanten erzeugt werden. Dadurch können diese beiden Schichten am Ende des Verfahrens bei niedrigen Temperaturen eindiffundiert werden.

Als elektrodenseitig wird die Seite einer Schicht bezeichnet, welche im fertigen Leistungshalbleiter 1 der Elektrode 5 zugewandt ist.

In FIG 2 ist ein Verfahren zur Herstellung eines Leistungshalbleiters 1 dargestellt, bei dem ausgehend von einer niedrig dotierten Schicht 6 eines ersten Ladungsträgertyps die Stoppschichten 3, 4 mittels Diffusionsverfahren erzeugt werden. Zur Bildung der ersten Stoppschicht 3 werden Teilchen des ersten Ladungsträgertyps 9 elektrodenseitig in eine niedrig dotierte Schicht 6 eines ersten Ladungsträgertyps implantiert und anschliessend bis zu einer vorgegebenen Tiefe 13 eingetrieben. Das Diffundieren von implantierten Teilchen in die Schicht ist in der Figur durch Pfeile mit dem Bezugszeichen 12 dargestellt. Dadurch wird eine mittel-dotierte Schicht 7 erzeugt. Der nunmehr verbleibende niedrig dotierte Teil der Schicht bildet die Driftschicht 2 im fertigen Leistungshalbleiter 1. Zur Bildung der zweiten Stoppschicht 4 werden anschliessend elektrodenseitig Teilchen des ersten Ladungsträgertyps 10 in die mittel-dotierte Schicht 7 implantiert und anschliessend bis zu einer vorgegebenen Tiefe 13 eingetrieben, wobei diese Tiefe geringer ist als die Tiefe, bis zu der die Teilchen 9 zur Bildung der ersten Stoppschicht 3 eingetrieben wurden. Durch dieses Eintreiben wird eine hoch dotierte Schicht 8 erzeugt. Der nunmehr verbleibende mittel-dotierte Teil der Schicht bildet die erste Stoppschicht 3 im fertigen Leistungshalbleiter 1. Vorteilhafterweise verwendet man bei der Herstellung des Leistungshalbleiters 1 eine dicke niedrig dotierte Schicht 6 des ersten Ladungsträgertyps, welche bei den einzelnen Schritten des Herstellungsverfahrens mechanische Robustheit bietet. Dieses Verfahren kann man deswegen mit Vorteil benutzen, um Leistungshalbleiter 1 für die Anwendung bei hohen Blockierspannungen herzustellen, da derartige Leistungshalbleiter 1 eine dicke Driftschicht 2 zur Aufnahme der hohen Spannungen aufweisen. Die mit diesem Verfahren hergestellten Leistungshalbleiter 1 können durch die zwei Diffusionsverfahren kostengünstig hergestellt werden. Die Stoppschichten 3, 4 werden wie in FIG 2 dargestellt und oben beschrieben gebildet, wobei die Stoppschichten 3, 4 mittels schnell diffundierenden Dopanten bei niedrigen Temperaturen erzeugt werden. Der nunmehr verbleibende niedrig dotierte Teil der Schicht 6 bildet die Driftschicht 2 im fertigen Leistungshalbleiter 1. Die Stoppschichten 3, 4 werden deshalb mittels schnell diffundierenden Dopanten erzeugt, da diese keine hohen Temperaturen benötigen, um in die niedrig dotierte Schicht 6 einzudiffundieren. Die Stoppschichten 3, 4 können daher erzeugt werden, ohne dass man den fast fertigen Leistungshalbleiter 1 hohen Temperaturen aussetzen muss.

In FIG 3 ist ein Verfahren zur Herstellung eines Leistungshalbleiters 1 dargestellt, bei dem ausgehend von einer niedrig dotierten Schicht 6 die Stoppschichten 3, 4 mittels epitaktischen Wachsens erzeugt werden. Auf einer niedrig dotierten Schicht 6, welche im fertigen Leistungshalbleiter 1 der Driftschicht 2 entspricht, wird eine erste Stoppschicht 3 durch epitaktisches Wachsen erzeugt. Das epitaktische Wachsen ist in der Figur durch Pfeile mit dem Bezugszeichen 15 dargestellt. Anschliessend wird auf der ersten Stoppschicht 3 elektrodenseitig eine hoch dotierte Schicht 8 durch epitaktisches Wachsen zur Bildung der zweiten Stoppschicht 4 erzeugt. Bei diesem Herstellungsverfahren kann vorteilhafterweise eine dicke niedrig dotierte Schicht 6 verwendet werden, weil sie bei den einzelnen Schritten des Herstellungsverfahrens mechanische Robustheit bietet. Das Verfahren kann man deswegen mit Vorteil nutzen, um Leistungshalbleiter 1 für die Anwendung bei hohen Blockierspannungen herzustellen, da derartige Leistungshalbleiter 1 eine dicke Driftschicht 2 zur Aufnahme der hohen Spannungen benötigen. Die mit epitaktischem Wachsen erzeugten Stoppschichten 3, 4 weisen eine gleichmässige Dotierung über die gesamte Dicke bis einschliesslich der Grenzen der Schichten auf.

In FIG 4 ist ein Verfahren zur Herstellung eines Leistungshalbleiters 1 dargestellt, bei dem ausgehend von einer niedrig dotierten Schicht 6 die erste Stoppschicht 3 mittels Diffusionsverfahren und die zweite Stoppschicht 4 mittels epitaktischen Wachsens erzeugt werden. Auf einer niedrig dotierten Schicht 6, welche im fertigen Leistungshalbleiter 1 der Driftschicht 2 entspricht, wird eine mittel-dotierte Schicht 7 durch epitaktisches Wachsen 15 erzeugt. Zur Bildung der zweiten Stoppschicht 4 werden anschliessend elektrodenseitig Teilchen des ersten Ladungsträgertyps 10 in die mittel-dotierte Schicht 7 implantiert und anschliessend bis zu einer vorgegebenen Tiefe 13 eingetrieben, wobei diese Tiefe 13 geringer ist als die Dicke der mittel-dotierten Schicht 7. Durch dieses Eintreiben wird eine hoch dotierte Schicht 8 erzeugt. Der nunmehr verbleibende mittel-dotierte Teil der Schicht bildet die erste Stoppschicht 3 im fertigen Leistungshalbleiter 1. Bei diesem Herstellungsverfahren kann vorteilhafterweise eine dicke niedrig dotierte Schicht 6 verwendet werden, weil sie bei den einzelnen Schritten des Herstellungsverfahrens mechanische Robustheit bietet. Das Verfahren kann man deswegen mit Vorteil nutzen, um Leistungshalbleiter 1 für die Anwendung bei hohen Blockierspannungen herzustellen, da derartige Leistungshalbleiter 1 eine dicke Driftschicht 2 zur Aufnahme der hohen Spannungen benötigen. Die mittels epitaktischen Wachsens erzeugte zweite Stoppschicht 4 weist eine gleichmässige Dotierung über die gesamte Dicke bis einschliesslich der Grenzen der Schicht auf. In FIG 5 ist ein Verfahren zur Herstellung eines Leistungshalbleiters 1 dargestellt, bei dem ausgehend von einer niedrig dotierten Schicht 6 eine erste Stoppschicht 3 mittels Diffusionsverfahren erzeugt wird. Zur Bildung der ersten Stoppschicht 3 werden Teilchen des ersten Ladungsträgertyps 9 elektrodenseitig in die niedrig dotierte Schicht 6 eines ersten Ladungsträgertyps implantiert und anschliessend bis zu einer vorgegebenen Tiefe 13 eingetrieben. Das Diffundieren von implantierten Teilchen in die Schicht ist in FIG 5 durch Pfeile mit dem Bezugszeichen 12 dargestellt. Dadurch wird eine erste Stoppschicht 3, welche mittel-dotiert ist, erzeugt. Anschliessend wird die Schicht 6 durch Bonding 16 mit einer hoch dotierten Schicht 8 verbunden, wobei die erste Stoppschicht 3 zwischen der niedrig dotierten Schicht 6 und der hoch dotierten Schicht 8 eingebettet wird. Ein Teil der niedrig dotierten Schicht 6 wird auf der Seite, die von der Elektrodenseite abgewandt ist, abgeschnitten, und der verbleibende niedrig dotierte Bereich der Schicht bildet die Driftschicht 2. Am Ende des Verfahrens wird ein teil der hoch dotierten Schicht 8 elektrodenseitig abgeschnitten, da die mechanische Stabilität nicht mehr erforderlich ist. Vorteilhafterweise verwendet man eine dicke hoch dotierte Schicht 8 welche, genügend mechanische Stabilität bei den Schritten des Herstellungsverfahrens des Leistungshalbleiter 1 bietet.

In FIG 6 wird von dem Endprodukt aus den Herstellungsverfahren nach einer der Figuren FIG 2 bis 5 ausgegangen. Dabei ist auf einer niedrig dotierten Driftschicht 2 eines ersten Ladungsträgertyps eine höher dotierte erste Stoppschicht 3 des ersten Ladungsträgertyps angeordnet, auf der wiederum eine hoch dotierte Schicht 8 des ersten Ladungsträgertyps angeordnet ist. Zur Bildung der Elektrode 5 werden Teilchen des zweiten Ladungsträgertyps 11 in die hoch dotierte Schicht 8 elektrodenseitig bis zu einer vorgegebenen Tiefe 13 diffundiert. Der nunmehr verbleibende hoch dotierte Teil der Schicht des ersten Ladungsträgertyps bildet die zweite Stoppschicht 4 im fertigen Leistungshalbleiter 1.

### Bezugszeichenliste

- 1: Leistungshalbleiter
- 2: Driftschicht
- 3: erste Stoppschicht
- 4: zweite Stoppschicht
- 5: Elektrode
- 6: niedrig dotierte Schicht
- 7: mittel-dotierte Schicht
- 8: hoch dotierte Schicht
- 9: Teilchen zur Schaffung einer ersten Stoppschicht
- 10: Teilchen zur Schaffung einer zweiten Stoppschicht
- 11: Teilchen zur Schaffung einer Elektrode
- 12: Diffundieren von implantierten Teilchen
- 13: Tiefe, bis zu der Teilchen in die Schicht eingetrieben werden
- 14: Schnitt durch Halbleiterschicht
- 15: epitaktisches Wachsen
- 16: Bonding

## Patentansprüche

1. Verfahren zur Herstellung eines Hochspannungs-Leistungshalbleiters (1) für den Betrieb bei hohen Blockierspannungen von grösser als 2000 V umfassend eine Driftschicht (2) mit einer Dotierung eines ersten Ladungsträgertyps von weniger als 5 * 10¹³/cm³ und einer Dicke von mehr als 150 µm,
eine erste Stoppschicht (3) mit einer Dotierung des ersten Ladungsträgertyps und
eine Elektrode (5) eines zweiten Ladungsträgertyps,
wobei die Dotierung der ersten Stoppschicht (3) höher ist als die Dotierung der Driftschicht (2);
bei welchem Verfahren zur Herstellung des Leistungshalbleiters (1) ausgehend von einer niedrig-dotierten Schicht (6) eines ersten Ladungsträgertyps, von welcher niedrig-dotierten Schicht (6) ein im fertigen Halbleiter verbleibender Teil mit niedriger Dotierung die Driftschicht (2) bildet, an einer Seite der niedrig-dotierten Schicht eine mittel-dotierte Schicht (7) erzeugt wird, von welcher mittel-dotierten Schicht (7) ein im fertigen Halbleiter verbleibender Teil mit mittlerer Dotierung die erste Stoppschicht (3) bildet, und
danach die Elektrode (5) in diejenige Schicht des ersten Ladungsträgertyps, welche die höchste Dotierung der Schichten des ersten Ladungsträgertyps aufweist, eindiffundiert wird, und
nach der Erzeugung der mittel-dotierten Schicht (7) und vor der Erzeugung der Elektrode (5) an derjenigen Seite der mittel-dotierten Schicht (7), welche der niedrig-dotierten Schicht (6) abgewandt ist, eine hoch dotierte Schicht (8) erzeugt wird, von welcher hoch dotierten Schicht (8) ein im fertigen Halbleiter verbleibender Teil mit hoher Dotierung eine zweite Stoppschicht (4) mit einer Dotierung des ersten Ladungsträgertyps bildet, wobei die Dotierung der hoch dotierten Schicht (8) höher ist als die Dotierung der mittel-dotierten Schicht (7), und nach der Eindiffundierung der Elektrode (5) Metallisierungen aufgebracht werden.

2. Verfahren nach Anspruch 1,
**dadurch gekennzeichnet, dass**
zur Bildung der ersten Stoppschicht (3) Teilchen des ersten Ladungsträgertyps in die niedrig-dotierte Schicht (6) implantiert und bis zu einer Tiefe, welche geringer als die Tiefe der niedrig-dotierten Schicht (6) ist, eingetrieben werden.

3. Verfahren nach Anspruch 1,
**dadurch gekennzeichnet, dass**
zur Bildung der ersten Stoppschicht (3) auf der niedrig dotierten Schicht (6) eine mittel-dotierte Schicht (7) durch epitaktisches Wachsen erzeugt wird.

4. Verfahren nach einem der Ansprüche 1 bis 3,
**dadurch gekennzeichnet, dass**
zur Bildung der zweiten Stoppschicht (4) Teilchen des ersten Ladungsträgertyps in die mittel-dotierte Schicht (7) implantiert und bis zu einer Tiefe, welche geringer als die Tiefe der mittel-dotierten Schicht (7) ist, eingetrieben werden.

5. Verfahren nach einem der Ansprüche 2 oder 3,
**dadurch gekennzeichnet, dass**
zur Bildung der zweiten Stoppschicht (4) die mittel-dotierte Schicht (7) mit einer hoch dotierten Schicht (8) durch Bonding (16) miteinander verbunden werden.

6. Verfahren nach einem Anspruch 5,
**dadurch gekennzeichnet, dass**
zur Bildung der zweiten Stoppschicht (4) die hoch dotierte Schicht (8) ausgedünnt wird.

7. Verfahren nach einem der Ansprüche 1 bis 6,
**dadurch gekennzeichnet, dass**
die zweite Stoppschicht (4) mit einer Dicke von (1 - 10) µm und/oder einer Dotierkonzentration von (2 * 10¹⁵ - 10¹⁷)/cm³ erzeugt wird.

8. Verfahren nach einem der Ansprüche 1 bis 7,
**dadurch gekennzeichnet, dass**
die erste Stoppschicht (3) mit einer Dicke von (10 - 30) µm und/oder einer Dotierkonzentration von (10¹³ - 2 * 10¹⁵)/cm³ erzeugt wird.

## Claims

1. Method for producing a high-voltage power semiconductor (1) for operation at high blocking voltages of greater than 2000 V comprising a drift layer (2) having a doping of a first charge carrier type of less than 5*10¹³/cm³ and a thickness of more than 150 µm,
a first stop layer (3) having a doping of the first charge carrier type, and
an electrode (5) of a second charge carrier type, wherein the doping of the first stop layer (3) is higher than the doping of the drift layer (2);
in which method for producing the power semiconductor (1), proceeding from a lightly doped layer (6) of a first charge carrier type, of which lightly doped layer (6) a part with low doping that remains in the finished semiconductor forms the drift layer (2), a medium-doped layer (7) is produced at one side of the lightly doped layer, of which medium-doped layer (7) a part with medium doping that remains in the finished semiconductor forms the first stop layer (3), and
the electrode (5) is then indiffused into that layer of the first charge carrier type which has the highest doping of the layers of the first charge carrier type, and
after the production of the medium-doped layer (7) and before the production of the electrode (5), at that side of the medium-doped layer (7) which is remote from the lightly doped layer (6), a highly doped layer (8) is produced, of which highly doped layer (8) a part with high doping that remains in the finished semiconductor forms a second stop layer (4) having a doping of the first charge carrier type, wherein the doping of the highly doped layer (8) is higher than the doping of the medium-doped layer (7), and metallizations are applied after the indiffusion of the electrode (5).

2. Method according to Claim 1,
**characterized in that**
in order to form the first stop layer (3), particles of the first charge carrier type are implanted into the lightly doped layer (6) and are driven in to a depth that is less than the depth of the lightly doped layer (6).

3. Method according to Claim 1,
**characterized in that**
in order to form the first stop layer (3) on the lightly doped layer (6) a medium-doped layer (7) is produced by epitaxial growth.

4. Method according to one of Claims 1 to 3,
**characterized in that**
in order to form the second stop layer (4), particles of the first charge carrier type are implanted into the medium-doped layer (7) and are driven in to a depth that is less than the depth of the medium-doped layer (7).

5. Method according to either of Claims 2 and 3,
**characterized in that**
in order to form the second stop layer (4), the medium-doped layer (7) together with a highly doped layer (8) are connected to one another by bonding (16).

6. Method according to Claim 5,
**characterized in that**
the highly doped layer (8) is thinned in order to form the second stop layer (4).

7. Method according to one of Claims 1 to 6,
**characterized in that**
the second stop layer (4) is produced with a thickness of (1 - 10) µm and/or a doping concentration of (2*10¹⁵ - 10¹⁷) /cm³.

8. Method according to one of Claims 1 to 7,
**characterized in that**
the first stop layer (3) is produced with a thickness of (10 - 30) µm and/or a doping concentration of (10¹³-2*10¹⁵) /cm³.

## Revendications

1. Procédé de fabrication d'un semi-conducteur de puissance à haute tension (1) destiné à fonctionner à de hautes tensions de blocage de plus de 2000 V comprenant une couche de glissement (2) avec un dopage d'un premier type de porteurs de charge de moins de 5*10¹³/cm³ et une épaisseur de plus de 150 µm,
une première couche d'arrêt (3) avec un dopage du premier type de porteurs de charge, et
une électrode (5) d'un deuxième type de porteurs de charge,
dans lequel le dopage de la première couche d'arrêt (3) est plus élevé que le dopage de la couche de glissement (2) ;
procédé de fabrication du semi-conducteur (1) dans lequel, en partant d'une couche faiblement dopée (6) d'un premier type de porteurs de charge, couche faiblement dopée (6) dont une partie avec un faible dopage restant dans le semi-conducteur terminé forme la couche de glissement (2), on produit une couche moyennement dopée (7) sur un côté de la couche faiblement dopée, couche moyennement dopée (7) dont une partie avec un dopage moyen restant dans le semi-conducteur terminé forme la première couche d'arrêt (3), et
l'électrode (5) est ensuite diffusée dans la couche du premier type de porteurs de charge, qui présente le dopage le plus élevé des couches du premier type de porteurs de charge, et
après la production de la couche moyennement dopée (7) et avant la production de l'électrode (5) sur le côté de la couche moyennement dopée (7) qui est tourné à l'opposé de la couche faiblement dopée (6), on produit une couche fortement dopée (8), couche fortement dopée (8) dont une partie avec un dopage élevé restant dans le semi-conducteur terminé forme une deuxième couche d'arrêt (4) avec un dopage du premier type de porteurs de charge, dans lequel le dopage de la couche fortement dopée (8) est plus élevé que le dopage de la couche moyennement dopée (7) et on dépose des métallisations après la diffusion de l'électrode (5).

2. Procédé selon la revendication 1, **caractérisé en ce que**, pour la formation de la première couche d'arrêt (3), on implante des particules du premier type de porteurs de charge dans la couche faiblement dopée (6) et on les fait pénétrer jusqu'à une profondeur, qui est inférieure à la profondeur de la couche faiblement dopée (6).

3. Procédé selon la revendication 1, **caractérisé en ce que**, pour la formation de la première couche d'arrêt (3) sur la couche faiblement dopée (6), on produit une couche moyennement dopée (7) par croissance épitaxiale.

4. Procédé selon l'une quelconque des revendications 1 à 3, **caractérisé en ce que**, pour la formation de la deuxième couche d'arrêt (4), on implante des particules du premier type de porteurs de charge dans la couche moyennement dopée (7) et on les fait pénétrer jusqu'à une profondeur qui est inférieure à la profondeur de la couche moyennement dopée (7).

5. Procédé selon l'une des revendications 2 ou 3, **caractérisé en ce que**, pour la formation de la deuxième couche d'arrêt (4), on assemble l'une à l'autre par liaison (16) la couche moyennement dopée (7) avec une couche fortement dopée (8).

6. Procédé selon la revendication 5, **caractérisé en ce que**, pour la formation de la deuxième couche d'arrêt (4), on réduit la couche fortement dopée (8).

7. Procédé selon l'une quelconque des revendications 1 à 6, **caractérisé en ce que** l'on produit la deuxième couche d'arrêt (4) avec une épaisseur de (1 - 10) µm et/ou une concentration de dopage de (2*10¹⁵ - 10¹⁷)/cm³.

8. Procédé selon l'une quelconque des revendications 1 à 7, **caractérisé en ce que** l'on produit la première couche d'arrêt (3) avec une épaisseur de (10 - 30) µm et/ou avec une concentration de dopage de (10¹³ - 2*10¹⁵) /cm³.
